# EUROPEAN PATENT SPECIFICATION

(11) **EP 2 234 162 B1**
(45) Date of publication and mention of the grant of the patent: **18.01.2017**
(21) Application number: 10005091.3
(22) Date of filing: 07.08.1998
(51) Int. Cl.: H01L 27/32

(54) **Organic electroluminescent display panel and method for fabricating the same**
Organische Elektrolumineszenzanzeige und Verfahren zu deren Herstellung
Panneau d'affichage électroluminescent en matière organique et procédé pour sa fabrication

(43) Date of publication of application: 29.09.2010
(62) Divisional of application: 98306353.8
(73) Proprietor: LG Electronics Inc., Seoul (KR)
(72) Inventor: Kim, Sung Tae, Seoul (KR); Yoon, Jong Geun, Seoul (KR); Kim, Chang Nam, Seoul (KR)
(74) Representative: Boult Wade Tennant

(56) References cited:
- EP-A2- 0 809 229
- JP-A- 2 187 787
- JP-A- 4 082 197
- US-A- 5 302 468
- US-A- 6 140 765

## Description

### BACKGROUND OF THE INVENTION

### Field of the Invention

The present invention relates to an organic electroluminescent (hereinafter referred to as EL) display panel comprising organic EL elements which emit light when electric charges are injected to an emitting layer.

### Discussion of the Related Art

The technology of organic EL devices, also called organic light emitting diodes (LEDs), has been rapidly advancing, and several prototype modules have been successfully demonstrated at exhibitions. Organic EL devices are extremely thin, matrix-addressable and operable at a relatively low voltage, typically less than 15 volts. Furthermore, they have additional features suitable for next generation flat panel displays (FPDs) such as, among other things, little dependence on viewing angle and good device-formability on flexible substrates. A major drawback of liquid crystal display, currently most well-known display of choice, is that most of them require bright backlighting, which can be easily eliminated by the use of an organic EL display.

Organic LEDs differ fundamentally from conventional inorganic LEDs. While the charge transfer in inorganics is band-like in nature and the electron-hole recombination results in the interband emission of light, organic films are generally characterized by the low-mobility activated hopping transport and the emission is excitonic. Organic EL devices are also substantially different from conventional inorganic EL devices, especially in that organic EL devices are operable at low DC voltages.

A substantial amount of research has been directed towards the efficiency improvement and color control of organic LEDs. The efficiency of organic EL devices has now been demonstrated to be certainly adequate for many commercial applications. Moreover, color control is probably not limiting for most potential applications. In light of this, we believe that the outlook for commercial applications is excellent for organic EL devices. The performance of the organic EL devices is quite satisfactory for many applications. It is valuable to think in terms of specific products and manufacturing techniques for the commercialization of organic EL devices. Consideration of the specific applications leads us to believe that more work on manufacturability, uniformity, reliability, and systems issues is required to commercialize organic EL.

For the applications to large flat panel displays, it is critical to have uniform emission over the whole display screen, which may be obtained only when the organic function layer is formed uniformly over the whole active viewing area. There is another important issue indirectly but closely associated with the fabrication of a large organic EL display panel, i.e. difficulties which arise from driving a large organic EL panel with a passive matrix addressing scheme. The simplest way to drive an organic EL panel is to have organic function layers sandwiched between two sets of orthogonal electrodes, i.e. rows and columns. In this passive addressing scheme, the EL element serves both the display and switching functions. The diode-like nonlinear current-voltage characteristic of the organic EL element should, in principle, permit a high degree of multiplexing in this mode of addressing. However, the problems to be discussed below become apparent as an organic EL display panel becomes large.

First, it is well known that the RC time delay is significant in an organic EL display due to somewhat poor conductivity of indium tin oxide (ITO), a typical material for transparent electrode, and relatively large capacitance component of organic layers. As the panel size increases, the time delay becomes prohibitively large. More importantly, an organic EL display element does not have an intrinsic memory and so needs a very high peak luminance for a passive matrix addressing, which limits the number of rows of the display panel. The instantaneous peak luminance is proportional to (number of row) x (average luminance). To achieve an average display luminance of 100 cd/m², for example, the maximum number of rows will probably be limited to less than 500. The estimation is made with the assumption that a peak luminance is 50,000 cd/m², which is not trivial to achieve, and the device stability will certainly be a critical issue at that high luminance. In addition, the instantaneously high current causes large IR potential drops along the column and row buses, which should contribute to the non-uniformity of brightness over the panel surface.

A solution to the problems discussed above is to employ an active addressing scheme as in a thin film transistor liquid crystal display (TFT-LCD). But an active matrix EL (AM-EL) is costly to fabricate, and, more importantly, becomes less competitive compared to other display technologies, for example plasma display panel (PDP), as the display size becomes large. Thus, it is highly in demand to devise a practical way to fabricate a large passive addressable organic EL panel.

EP 0809229 discloses a drive device for scanning a monolithic integrated LED array.

### SUMMARY OF THE INVENTION

Accordingly, the present invention is directed to an organic electroluminescent display panel that substantially addresses one or more of the problems due to limitations and disadvantages discussed in the above.

An object of the present invention is to provide a passive addressable organic electroluminescent display panel with a plurality of sub-panels and a method for manufacturing the same.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

The present invention provides a passive electroluminescent panel as set out in claim 1.

There is provided an organic electroluminescent display panel having a plurality of emitting portions comprising:
a transparent substrate;
a plurality of first electrodes formed on said transparent substrate, each first electrode made up of a plurality of stripes which are electrically isolated from each other, each stripe electrically connected to a first bus electrode made up of a single or a plurality of electrically conducting materials, each first bus electrode, if necessary, vertically stacked with an electrically insulating layer in between, each of said stacked layers made up of one or a plurality of first bus electrodes arranged side by side with an electrically insulating gap in between;
organic function layers formed on said first electrodes, including at least one organic EL medium layer; and
a plurality of second electrodes formed on said organic function layers, each second electrode made up of a plurality of stripes which are electrically isolated from each other, each stripe electrically connected to a second bus electrode made up of a single or a plurality of electrically conducting materials, each second bus
   electrode, if necessary, vertically stacked with an electrically insulating layer in between, each of said stacked layers made up of one or a plurality of second bus electrodes arranged side by side with an electrically insulating gap in between.

There is further provided an organic electroluminescent (EL) display panel comprising:
a plurality of sub-panels divided into a plurality of emitting portions;
a substrate on which a plurality of first electrodes corresponding to the sub-panels and a plurality of first signal buses coupled to corresponding first electrodes are formed;
a plurality of second signal buses insulatively projecting from the substrate for exposing at least portions of the first electrodes respectively;
at least one of first organic function layers, second organic function layers and third organic function layers formed on the exposed portions of the first electrodes, each of said first organic function layers, second organic function layers and third organic function layers including at least one organic electroluminescent medium; and
a plurality of second electrodes formed on said at least one of first, second and third organic function layers and coupled to corresponding second signal buses.

Preferably, said plurality of sub-panels are arranged in nxm array of sub-panels, where n and m are integers greater than 2.

The organic EL display panel may further comprise a plurality of ramparts formed on corresponding second signal buses.

Preferably, a corresponding second electrode is formed on each rampart.

Preferably, a corresponding said at least one of first, second and third organic function layers is formed between the corresponding second electrode and each rampart.

The organic EL display panel may further comprise a rampart formed on a corresponding first signal bus located between adjacent sub-panels.

Preferably, each of said plurality of first and second electrodes comprises a plurality of first and second conductive layers, respectively, arranged in an array of rows and columns, each of said first and second conductive layers being isolated from each other.

Preferably, said plurality of first conductive layers is made of a light transmissive material.

Preferably, the light transmissive material is indium tin oxide.

Preferably, said substrate is light transmissive.

Preferably, said first conductive layers have a substantially rectangular shape.

Preferably, a corresponding first conductive layer in a corresponding sub-panel includes a plurality of notches on one side of the substantially rectangular shape.

Preferably, said plurality of second conductive layers is made of one of a low resistance metal and alloy.

Preferably, the low resistance metal is aluminium, and the alloy is one of Mg:Ag and Al:Li.

Preferably, said plurality of first signal buses is formed in a row direction between at least one of adjacent first conductive layers for coupling at a first side of a corresponding first conductive layer and corresponding first conductive layers for coupling at a second side, wherein the first and second sides are different sides of the first conductive layers.

Preferably, said plurality of second signal buses is formed in a row direction between at least one of adjacent second conductive layers for coupling at a first side of a corresponding second conductive layer and corresponding second conductive layer for coupling at a second side, wherein the first and second sides are different sides of the second conductive layers.

Preferably, each of said plurality of first signal buses comprises at least one conductive first connection formed on the substrate and a first insulating layer covering said conductive first connection and each of said plurality of second signal buses comprises a second insulation layer formed on the first conductive layer, at least one conductive second connection formed on the first conductive layer and a third insulation layer formed on the conductive second connection.

Preferably, each of said conductive first and second connections are made of at least one conductive material.

Preferably, the conductive material is at least one of a metal, an alloy and a conducting polymer.

Preferably, the metal is one of aluminum, copper, nickel, chromium, silver and gold.

Preferably, at least one of the conductive first connection is in contact with an entire first side of the corresponding first conductive layer and the conductive second connection is in contact with an entire first side of the corresponding second conductive layer.

Preferably, the first insulating layer isolates adjacent conductive first connections when there is more than one conductive first connection for each first signal bus and said third insulating layer isolates adjacent conductive second connections when there is more than one conductive connection for each second signal bus.

Preferably, at least one of the adjacent conductive first and second connections are vertically stacked.

There is provided a new method for manufacturing an organic EL display panel having a plurality of emitting portions, comprising the steps of:
forming a plurality of first electrodes, each first electrode made up of a plurality of stripes which are electrically isolated from each other;
forming the first set of first bus electrodes, each first bus electrode electrically connected to a corresponding first electrode;
forming the second set of first bus electrodes on top of an insulating layer which is, in turn, formed on said first set of first bus electrodes, or alternatively forming the second set of first bus electrodes laterally next to corresponding first bus electrodes of said first set, and, in any cases, each first bus electrode electrically connected to a corresponding first electrode;
repeating thereafter, if necessary, the formation of further sets of first bus electrodes in such a way as described in the above;
forming the first set of second bus electrodes and their connection pads by which second bus electrodes are to be electrically connected to corresponding second electrodes being deposited in a following step;
forming the second set of second bus electrodes on top of an insulating layer which is, in turn, formed on said first set of second bus electrodes, or alternatively forming the second set of second bus electrodes laterally next to corresponding second bus
   electrodes of said first set, and, in any cases, the second set of second bus electrodes having connection pads by which said second bus electrodes are to be electrically connected to corresponding second electrodes being deposited in a following step;
repeating thereafter, if necessary, the formation of further sets of second bus electrodes in such a way as described in the above;
laminating, at least on said first electrodes, organic function layers including at least one organic EL medium layer;
etching out portions of organic function layers deposited on top of the connection pads for second electrodes to expose the surface of said connection pads; and
forming second electrodes on top of said organic function layers and said exposed surface of the connection pads, making electrical connections between said second electrodes and corresponding connection pads;

It is to be understood that both the foregoing general description and the following detailed description are exemplary and explanatory, and are intended to provide further explanation of the invention as claimed.

### BRIEF DESCRIPTION OF THE DRAWING

The accompanying drawings, which are included to provide further understanding of the invention, and are incorporated in, and constitute a part of this specification, illustrate embodiments of the invention, and together with the description serve to explain the principles of the invention.

In the drawings:
Fig. 1 illustrates a plan view of an organic EL display panel in accordance with a preferred embodiment of the present invention;
Fig. 2 shows a plan view of a display panel having (4 × 4) sub-panels:
Fig. 3 is a schematic view illustrating the process of forming a plurality of first electrodes and a plurality of contact pads for first and second electrodes;
Fig. 4 is a schematic view illustrating the process of electrically connecting stripes of first electrodes and corresponding contact pads;
Fig. 5 (a) is a close-up view of the four sub-panels designated as 2-f in Fig. 4, and Fig. 5(b) illustrates a cross-sectional view taken along the line A-A' in Fig. 5(a);

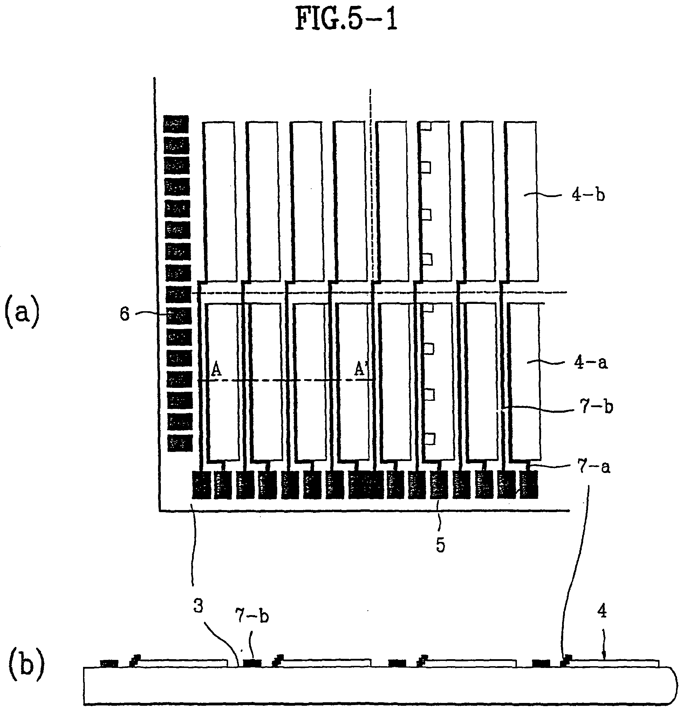

Fig. 5-1 depicts another way of electrically connecting stripes of first electrodes and corresponding contact pads;

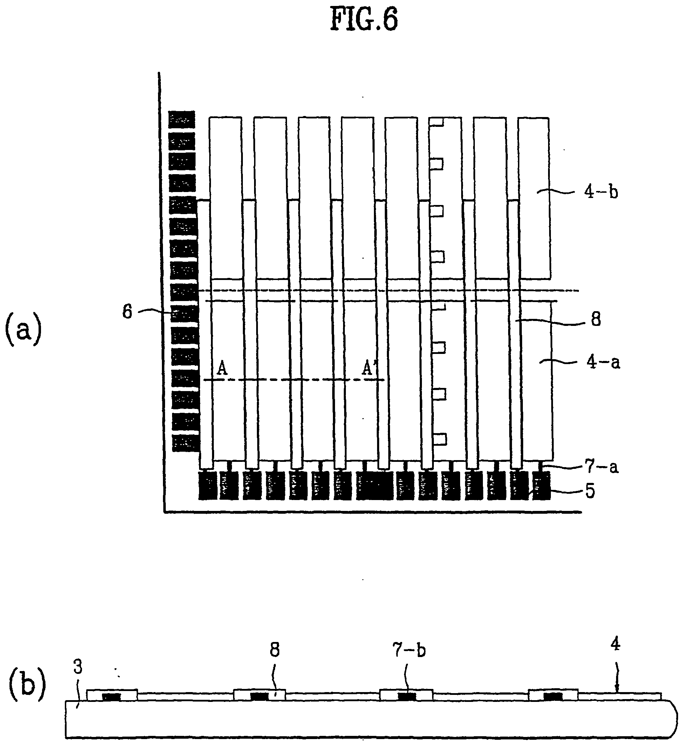

Fig. 6 is a plan view showing the process of covering first bus electrodes with an insulating layer;

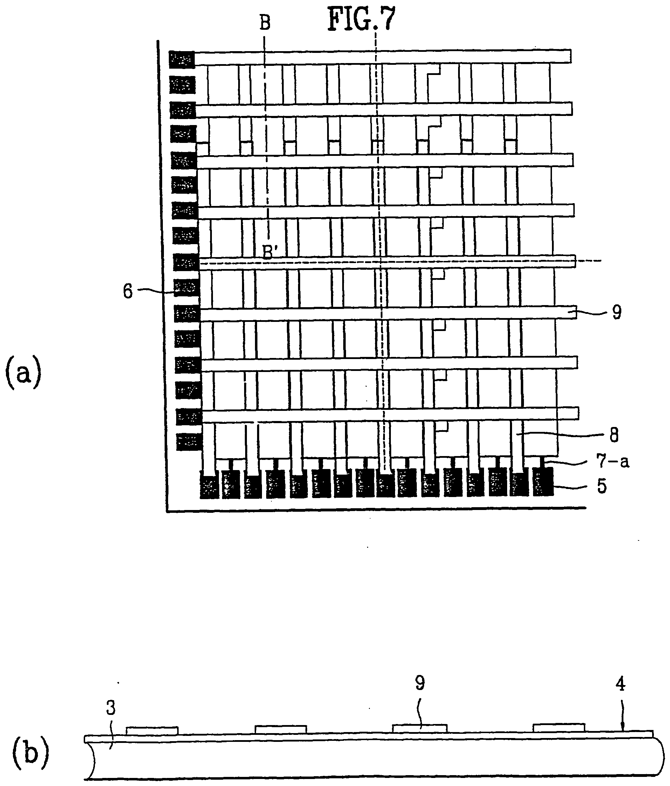

Fig. 7(a) is a schematic view illustrating the process of forming an insulating buffer layer for second bus electrodes, and Fig. 7(b) illustrates a cross-sectional view taken along the line B-B' in Fig. 7(a);

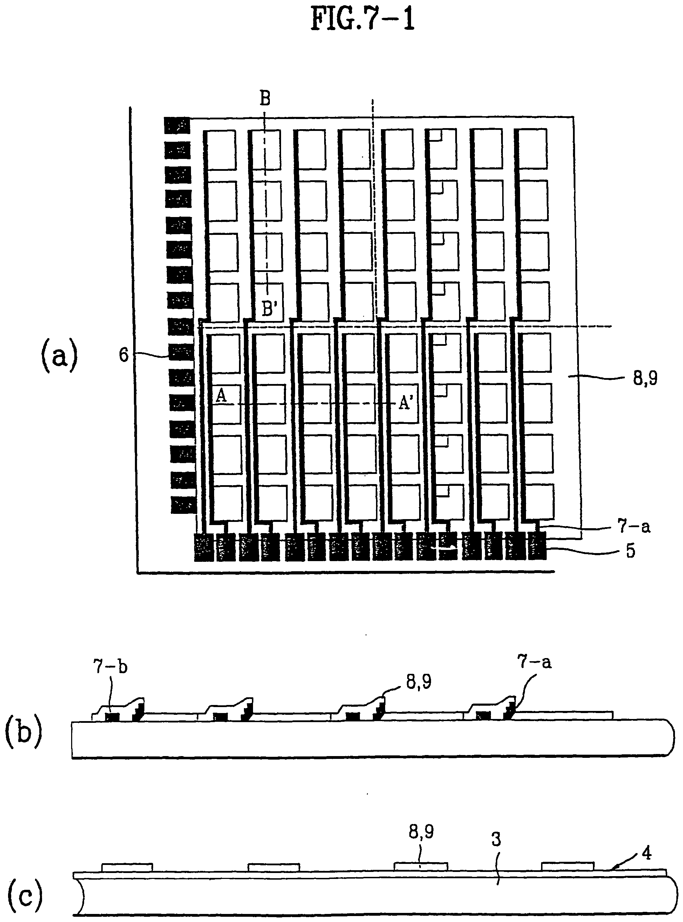

Fig. 7-1 (a) illustrates a process wherein the two steps concerning Figs. 6 and 7 are performed together in a step; Figs. 7-1(b) and 7-1(c) show cross-sectional views taken along the lines A-A' and B-B', respectively;

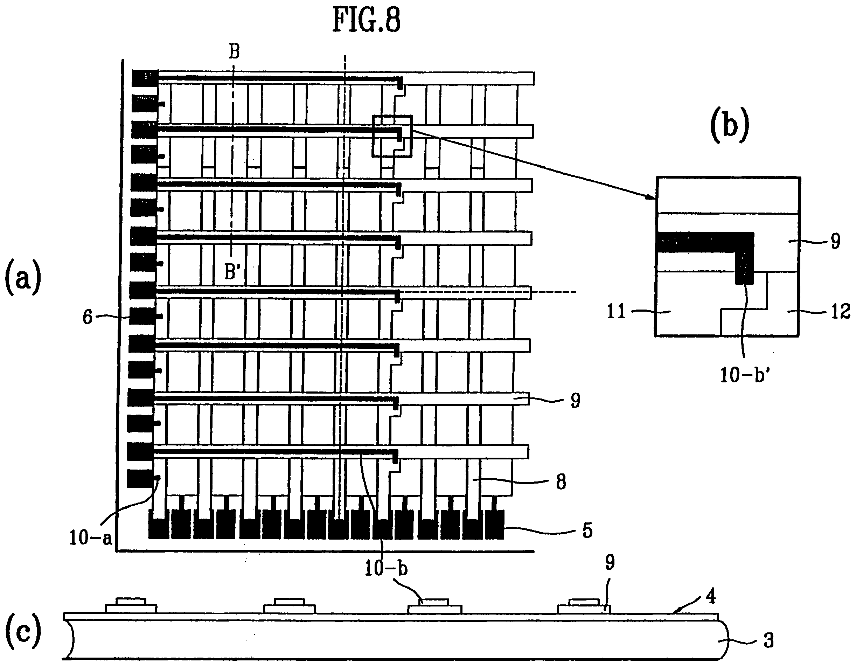

Fig. 8(a) is a plan view illustrating the process of forming second bus electrodes: Fig. 8(b) is an enlarged view, and Fig. 8(c) illustrates a cross-sectional view taken along the line B-B' in Fig. 8(a);

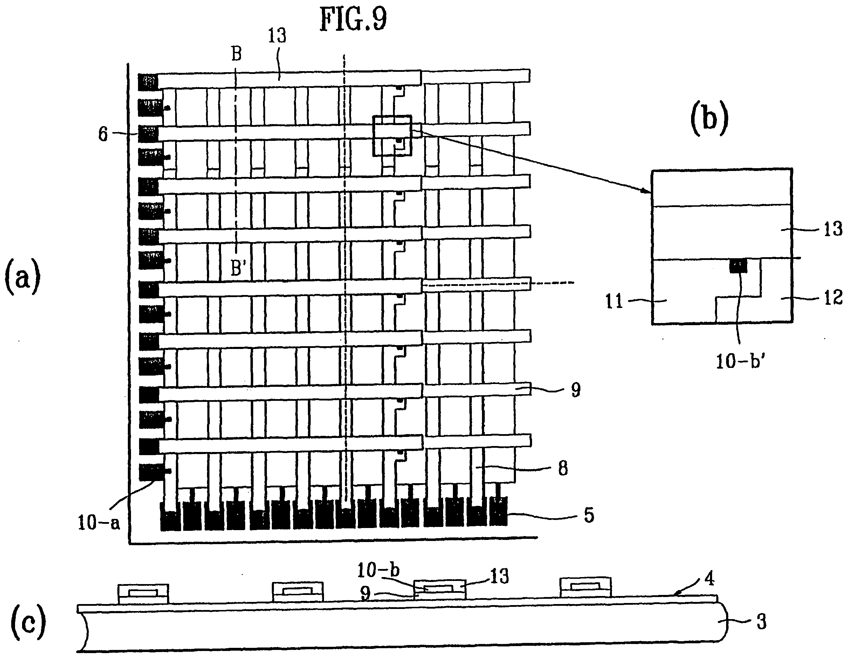

Fig. 9 is a plan view illustrating the process of forming an insulating layer for second bus electrodes;

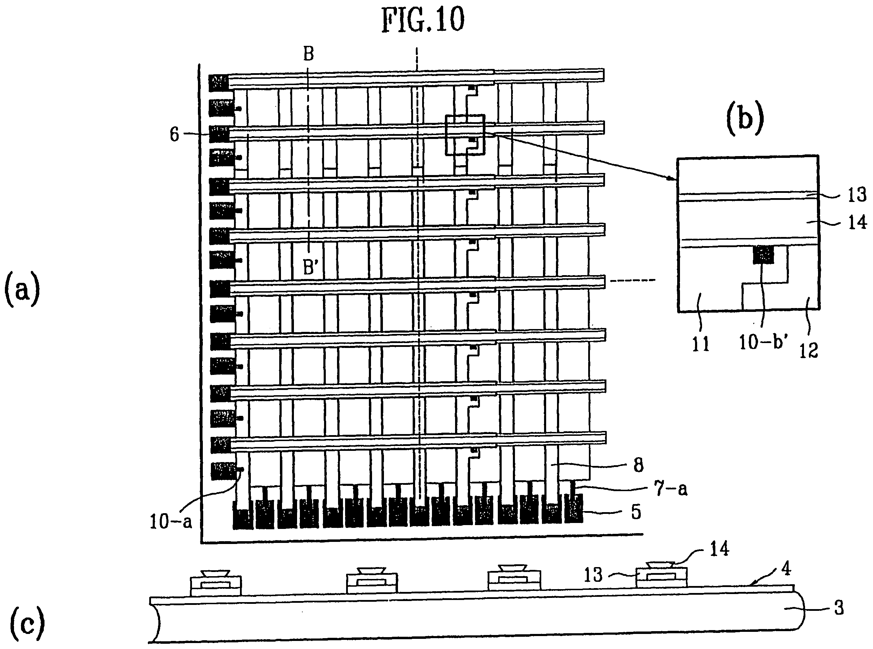

Fig. 10 illustrates the process of forming electrically insulating ramparts for pixelation;

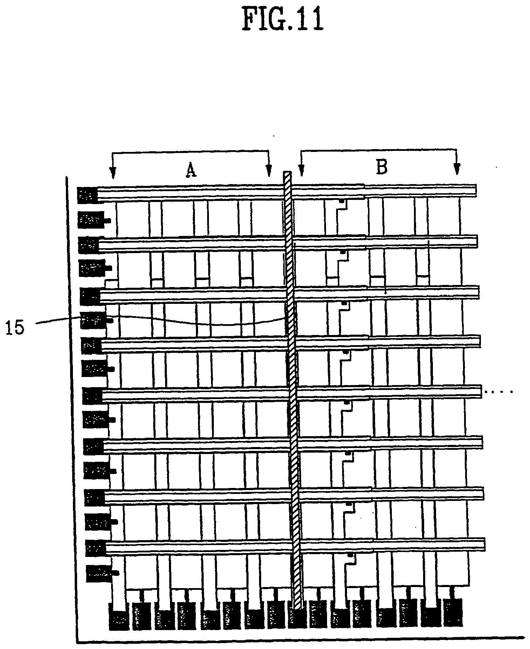

Fig. 11 exhibits the process of forming electrically insulating ramparts for electrically isolating second electrodes in A region from those in B region;

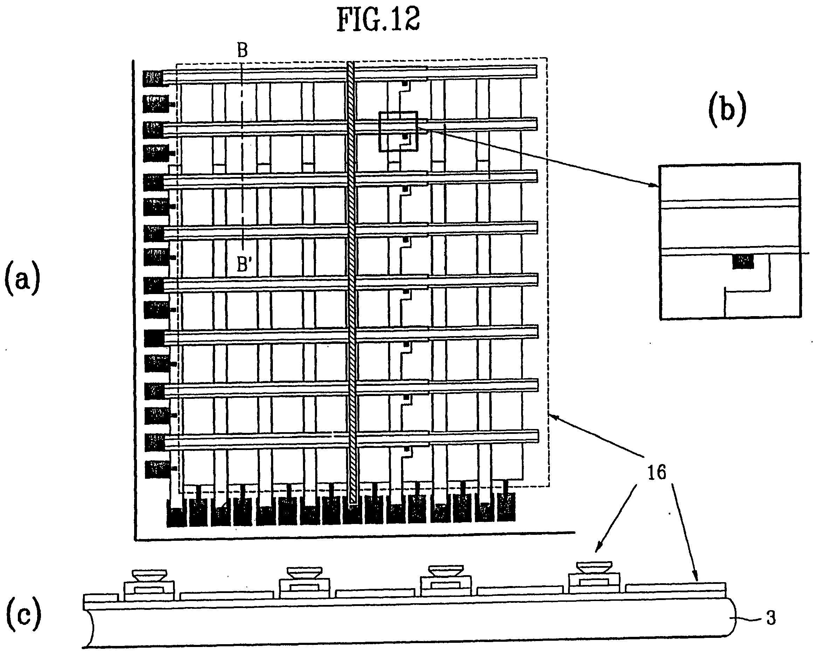

Fig. 12(a) illustrates the process of laminating organic function layers; Fig. 12(b) is a blow-up, and Fig. 12(c) shows a cross-sectional view taken along the line B-B' in Fig.12(a);

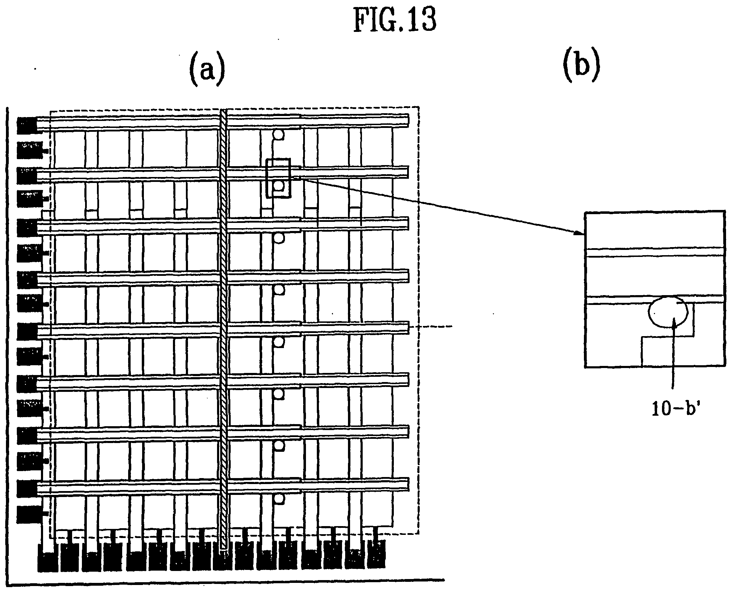

Fig. 13(a) illustrates the process of exposing a part of second bus electrode 10-b' by etching out organic function layers on top of said bus electrode 10-b'; Fig. 13(b) is a close-up;

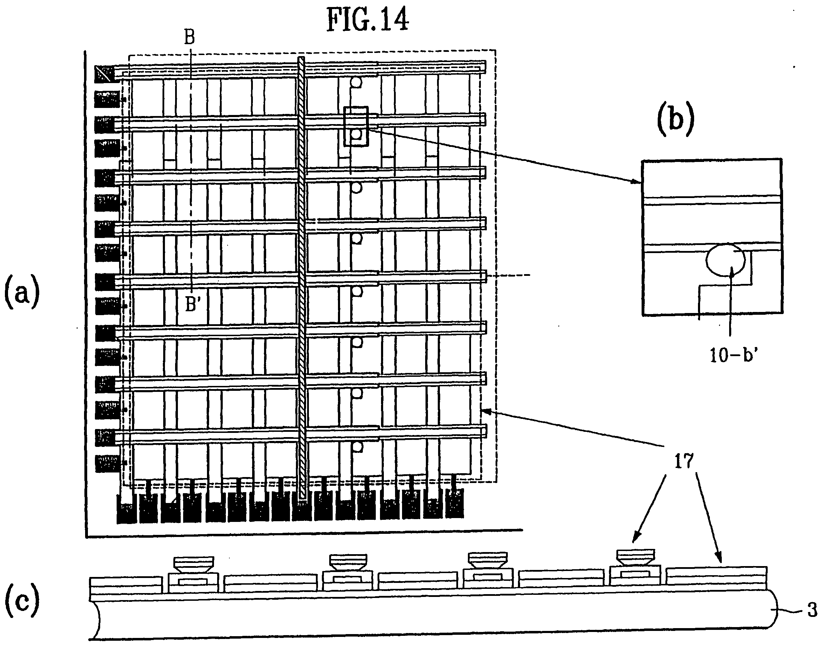

Fig. 14(a) illustrates the process of forming second electrodes; Fig. 14(b) is an enlarged view, and Fig. 14(c) shows a cross-sectional view taken along the line B-B' in Fig.14(a);

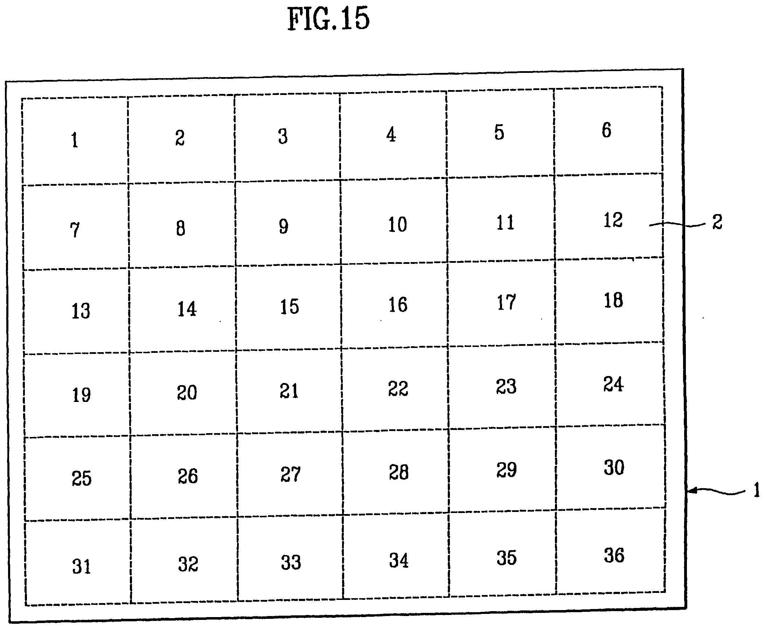

Fig. 15 shows a plan view of a display panel having (6 × 6) sub-panels;

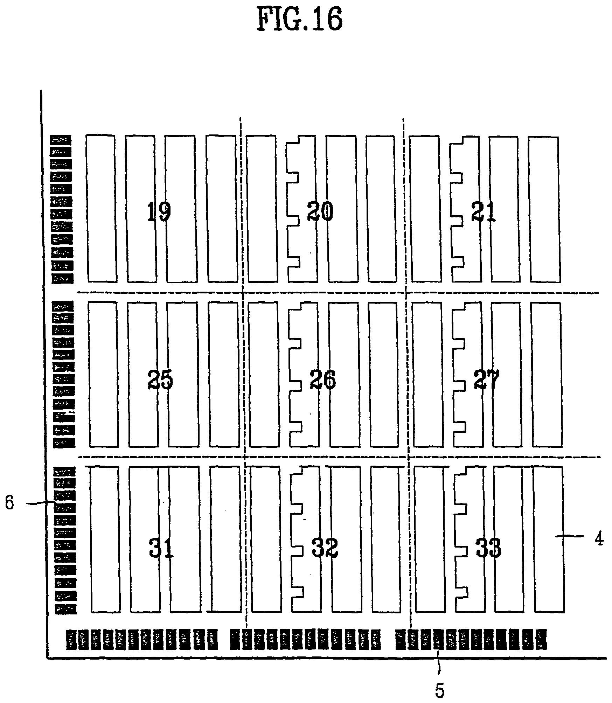

Fig. 16 is a close-up view illustrating the process of forming a plurality of first electrodes and a plurality of contact pads for first and second electrodes;

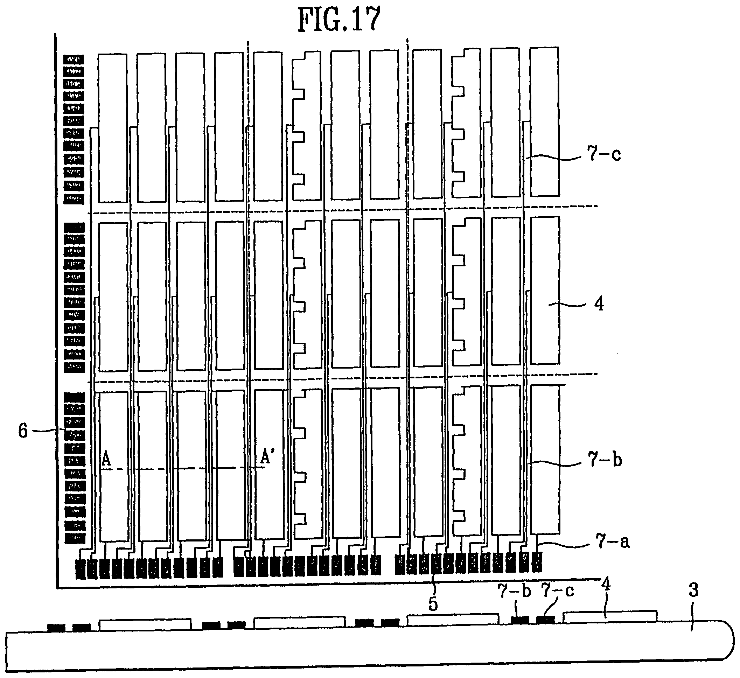

Fig. 17(a) is a schematic view illustrating the process of connecting stripes of first electrodes and corresponding contact pads, and Fig. 17(b) illustrates a cross-sectional view taken along the line A-A' in Fig. 17(a);

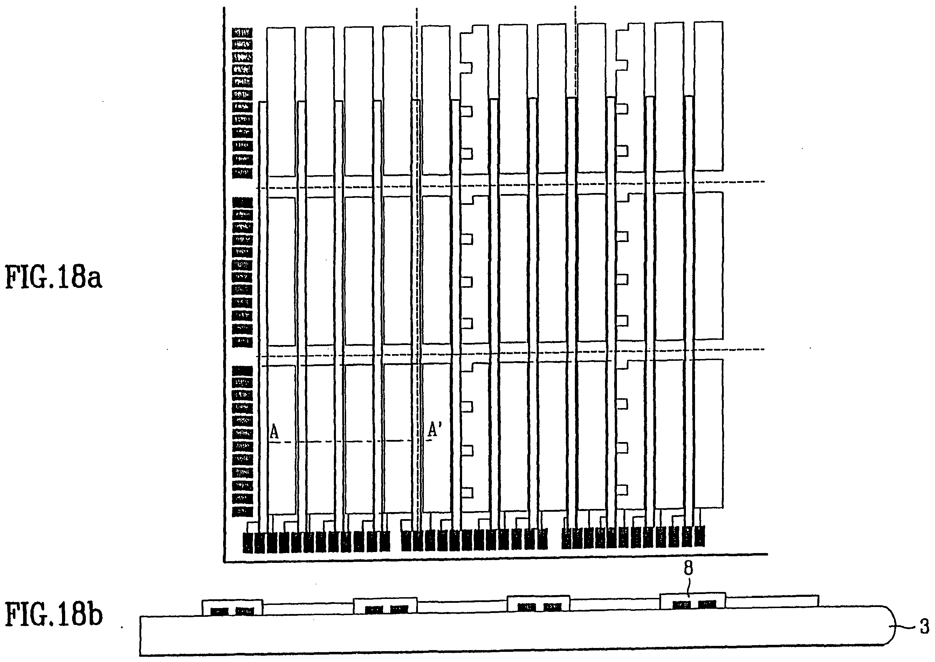

Fig.18(a) is a plan view showing the process of covering first bus electrodes with an insulating layer, and Fig.18(b) illustrates a cross-sectional view taken along the line A-A' in Fig. 18(a);

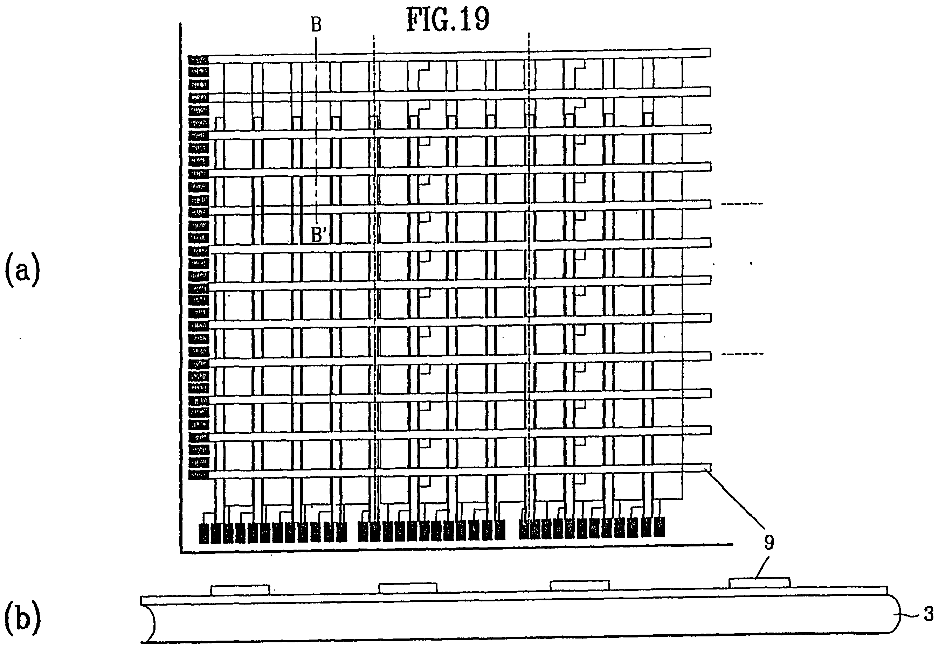

Fig. 19 is a schematic view illustrating the process of forming an insulating buffer layer for second bus electrodes;

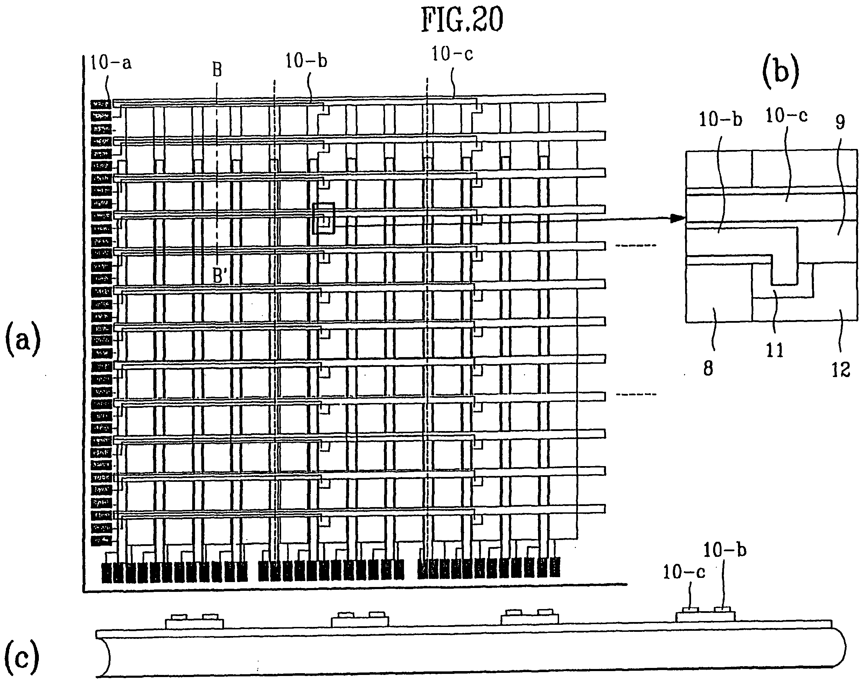

Fig. 20(a) is a schematic view illustrating the process of forming second bus electrodes;
Fig. 20(b) is a blow-up, and Fig. 20(c) illustrates a cross-sectional view taken along the line B-B' in Fig. 20(a);

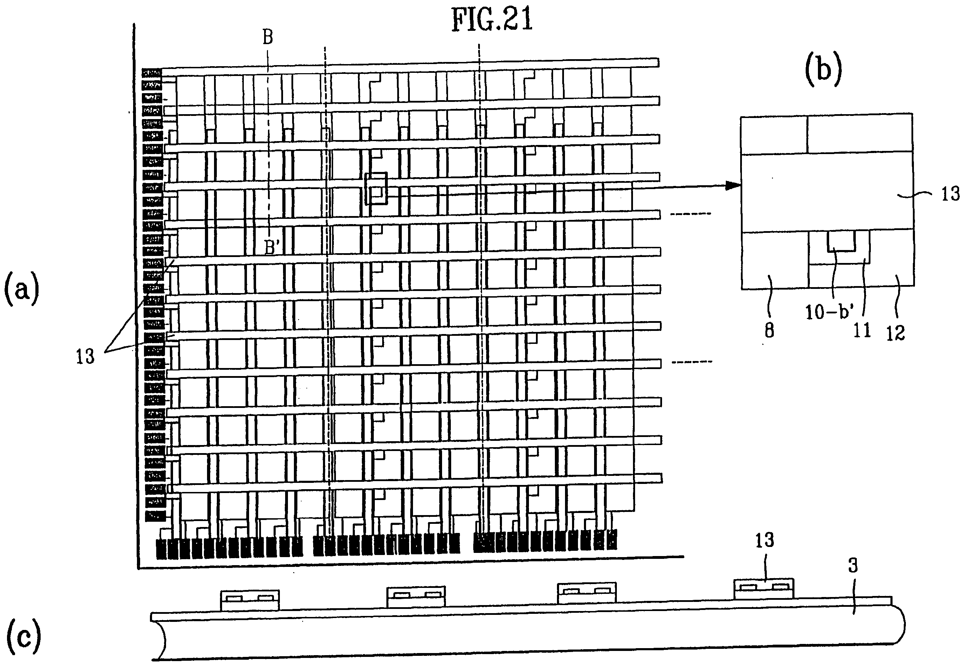

Fig. 21 is a plan view illustrating the process of forming an insulating layer for second bus electrodes;

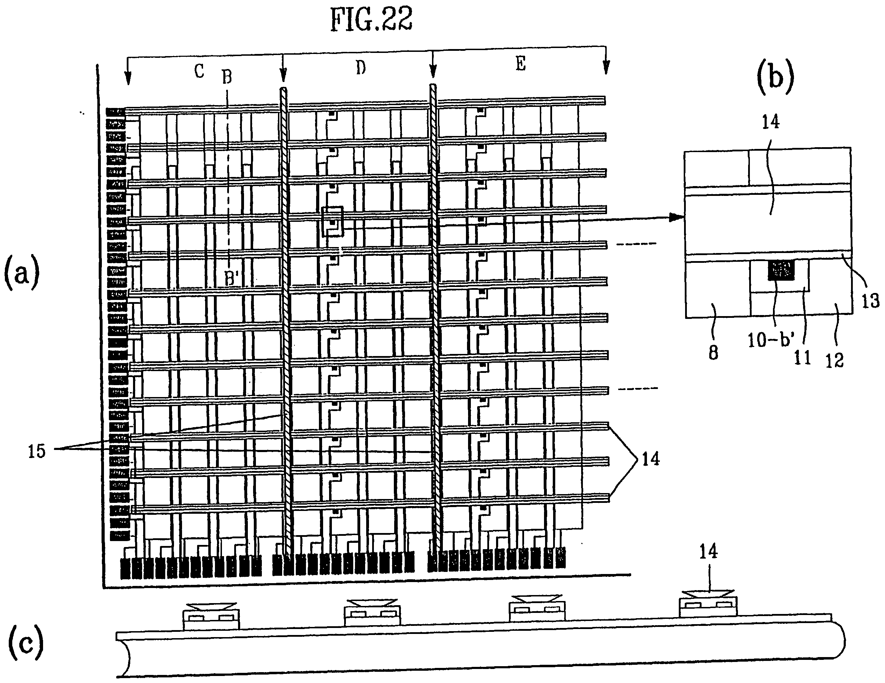

Fig. 22 illustrates the process of forming electrically insulating ramparts for separating second electrodes laterally and also those for isolating the groups of second electrodes in C, D and E regions;

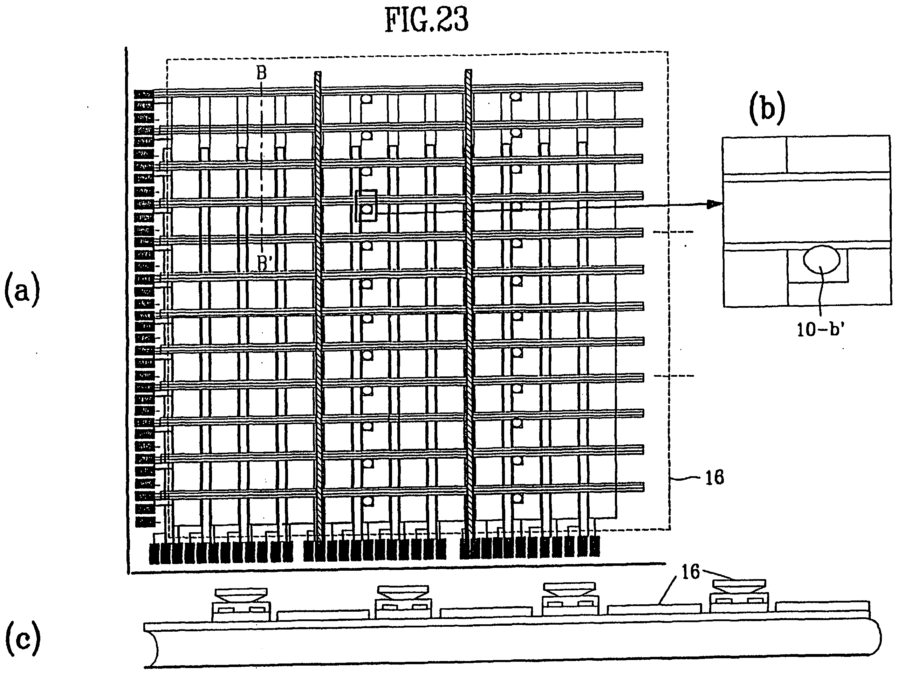

Fig. 23 illustrates the process of laminating organic function layers and exposing a part of second bus electrode 10-b' by etching out organic function layers on top of said bus electrode 10-b';

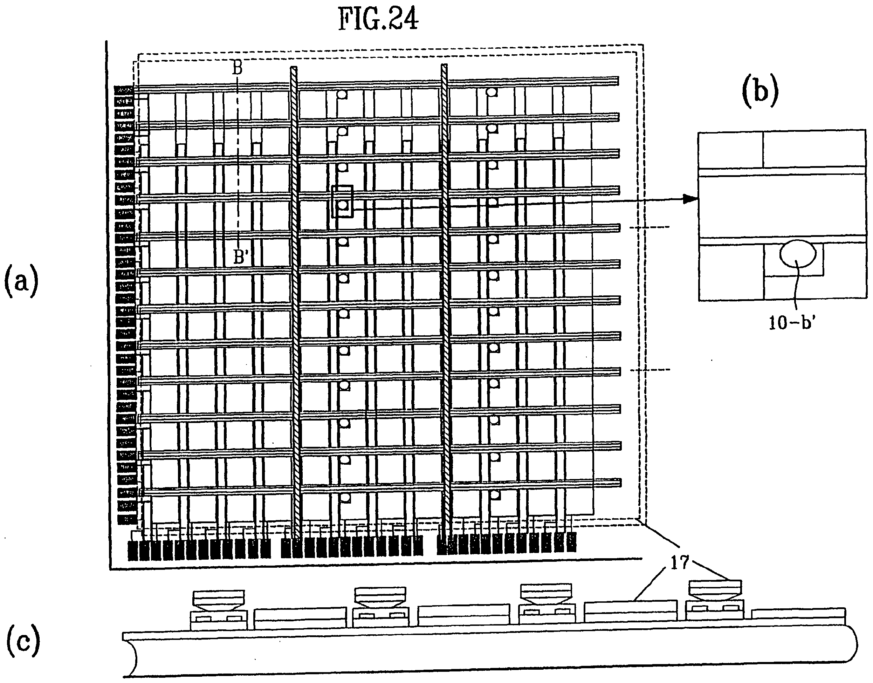

Fig. 24 illustrates the process of forming second electrodes;

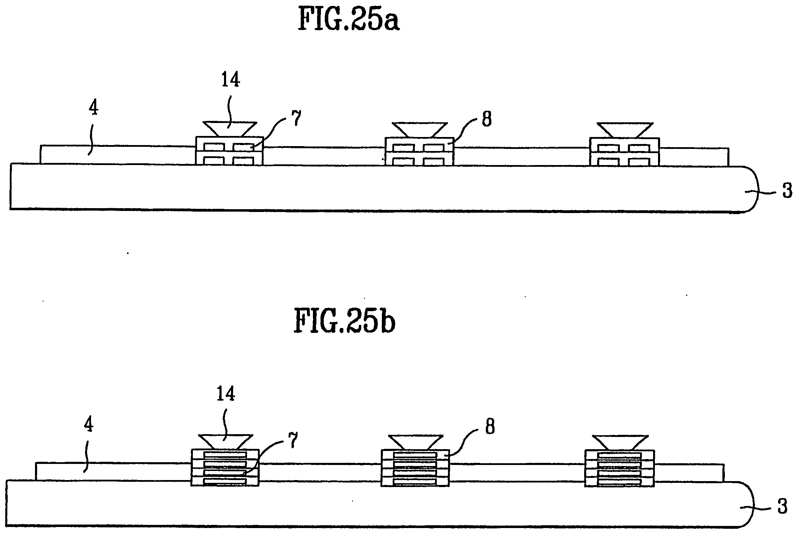

Fig. 25 is a sectional view illustrating the prototypical methods of forming a multilayer of second bus electrodes: (a) two lanes of bus electrode per layer and (b) a single lane per layer; and

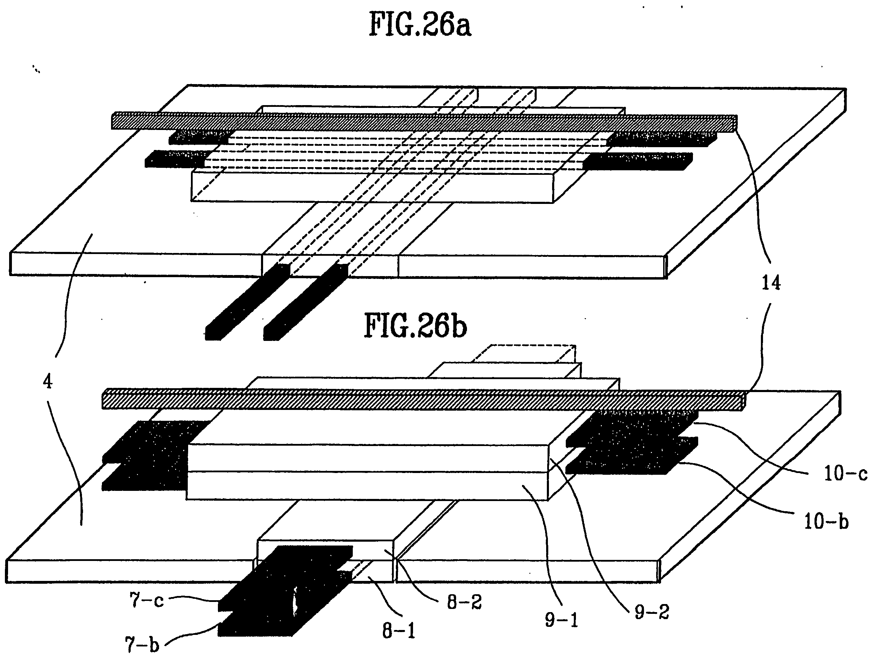

Fig. 26 is a perspective view describing the intersections of first and second bus electrodes: (a) two lanes of bus electrode per layer and (b) a single lane per layer.

### DETAILED DESCRIPTION OF THE PREFERRED EMBODIMENT

Reference will now be made in detail to the preferred embodiments of the present invention, examples of which are illustrated in the accompanying drawings.

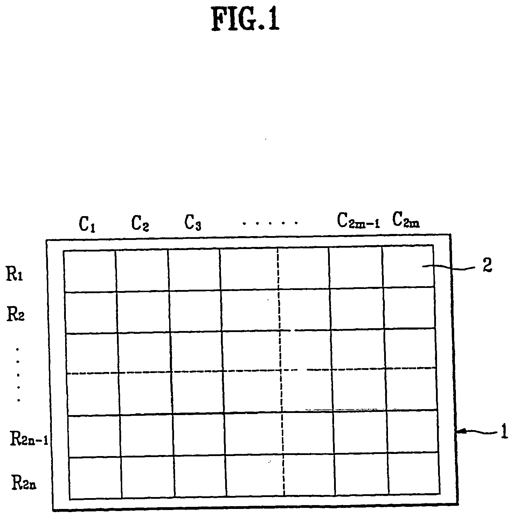

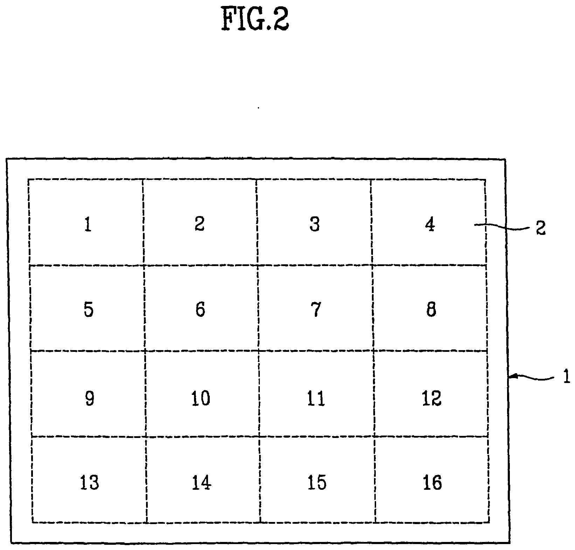

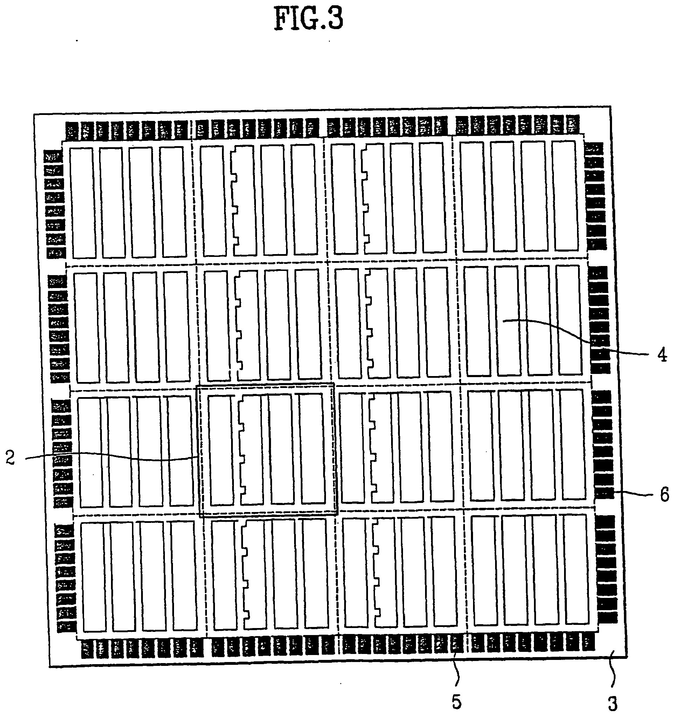

Fig. *1 schematically illustrates a plan view of an organic EL display panel in accordance with a preferred embodiment of the present invention. The organic EL display panel 1 has a large viewing area which is divided into sub-panels 2 of (2m x 2n), i.e. columns of 2m and rows of 2n, wherein m and n are integers greater than 2. Each sub-panel will be electrically driven separately to obviate the problems associated with a passive addressing of a large panel. Fig. 2 shows specitically a display panel having (4 x 4) sub-panels. The panel 1 has an active viewing area which is constituted of sixteen sub-panels 2. A series of fabrication steps devised in the present invention have been illustrated in Figs. 3∼14 for an exemplary display panel having (4 x 4) sub-panels.

In the first processing step (Fig. 3), a layer of transparent conductor(s), typically indium tin oxide (ITO), is deposited on a transparent, insulating substrate 3 and said deposited layer is patterned into a plurality of stripes 4 by photolithography. Said first electrode is apparently different from an anode used in a typical matrix addressing in that each first electrode is divided into 4 stripes. Each stripe of an electrode is electrically isolated from others, which can be utilized to drive each sub-panel 2 of the display panel separately. Fig. 3 also shows a plurality of contact pads 5 & 6 for first and second electrodes, respectively, formed on the transparent substrate. Said contact pads may be formed simultaneously during the formation of first electrodes.

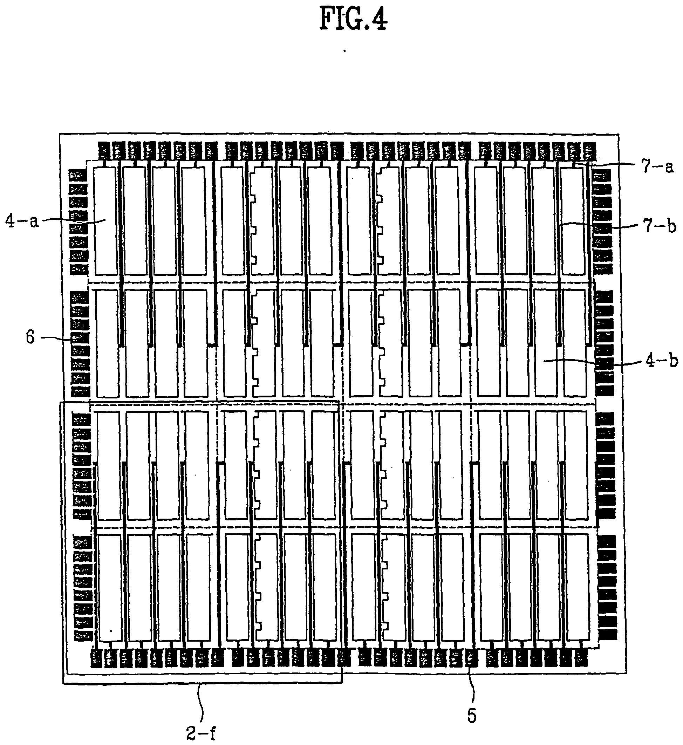

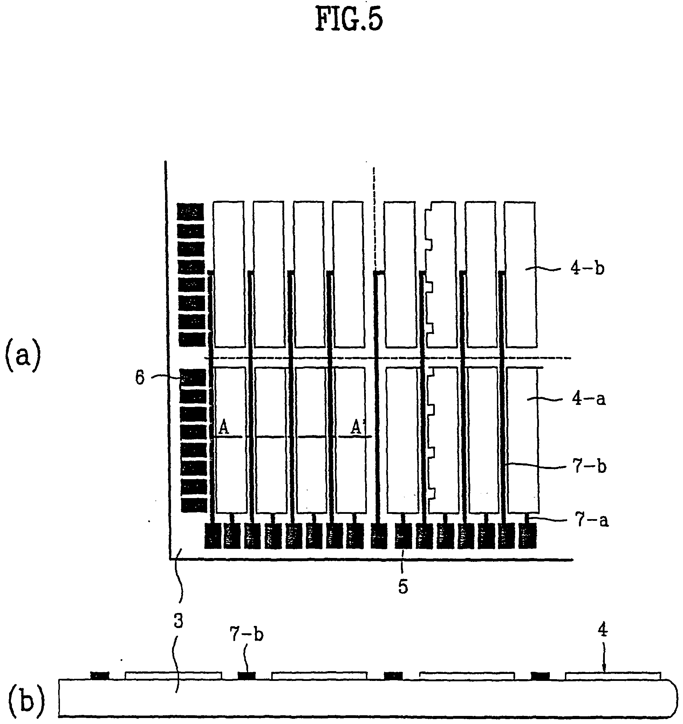

Next, electrical connections between stripes of first electrodes and corresponding contact pads are made through first bus electrodes. The short connections 7-a between outer stripes 4-a and corresponding contact pads 5 are also shown in Fig. 4, but the connections may be rather simply made during the previous step by patterning ITO in such a shape that the two are simply connected. The long connections between inner stripes 4-b and corresponding contact pads 5 are made through first bus electrodes 7-b which are formed preferably of a highly conductive metal such as aluminum or its alloys. There are several different ways to form said first bus electrodes 7-b, and a preferred method is to form the bus electrode only on the selective position using a lift-off process. The film growth may be performed using any of vapor deposition, e-beam evaporation. RF sputtering, chemical vapor deposition (CVD), spin coating, dipping, Dr. blade method, electro- and electroless platings, and screen printing method, among other things. Fig. 5(a) is a close-up view of four sub-panels designated as 2-f in Fig. 4. and Fig. 5(b) illustrates a cross-sectional view taken along the line A-A' in Fig. 5(a).

IR potential drops along a long side of each rectangular-shaped stripe of first electrodes can be significantly reduced by increasing the contact area between each of first bus electrodes and a corresponding stripe of first electrodes, which thereby makes a contribution towards a uniform emission of a sub-panel. In a sense, said first bus electrode serves as an auxiliary electrode for a stripe of first electrode because the electrical resistance of ITO, typically used for a first electrode, is much larger than that of a metal used for a bus electrode. A preferred way is to form each bus electrode along a long side of corresponding rectangular-shaped stripe, as shown in Fig. 5-1, making the two in electrical contact over the entire length of a long side of said stripe or over a substantial fraction of the whole length of said long side. Said contacts can be either continuous or evenly distributed lengthwise along the long side of said stripe.

In the next step, a layer of electrically insulating material(s) is formed on top of said first bus electrodes 7-b (see Fig. 6). Said layer 8 is required to be mechanically and chemically stable, and may be made of organic or inorganic insulating material(s). Preferred materials are inorganic compounds such as silicon oxide and silicon nitride and the film growth may be performed using any of vapor deposition, e-beam evaporation, RF sputtering, chemical vapor deposition (CVD), spin coating, dipping, Dr. blade method, electro- and electroless platings, and screen printing method.

Fig. 7(a) is a schematic view illustrating the process of forming an insulating buffer layer on top of which second bus electrodes are to be formed orthogonal to first bus electrodes in the following step. The role of said buffer layer 9 is to electrically isolate second bus electrodes from first electrodes. The materials and film growth methods used to form said buffer layer are basically the same as those for the insulating layer 8 in Fig. 6. Said buffer layer may be formed together with the insulating layer 8 in the previous step (see Fig. 7-1).

In the next step, second bus electrodes are formed to be orthogonal to first bus electrodes, as shown in Fig. 8. The role of said bus electrodes is to electrically connect contact pads 6 and second electrodes which are to be formed in the next process. The short connections 10-a may be omitted depending on the structural design employed. The long connections 10-b are formed mostly on top of the insulating layer 9, and, as shown in Fig. 8(b), a part of said bus electrode (10-b') is formed on an open area 11 which is not covered with the first electrode layer 4 (ITO) unlike the area 12. Second bus electrodes can be formed using the same materials and film growth methods as for first bus electrodes.

Next, an insulating layer is formed on top of said second bus electrodes as in Fig. 9. The materials and fabrication methods of said insulating layer are basically the same as those described earlier.

It should be noted in passing that second bus electrodes may be formed before first bus electrodes.

Depending on the mode of display and pixelation scheme adopted, next processing steps may vary substantially. As an example, if one chooses to separate adjacent pixels using electrically insulating ramparts as suggested in U.S. Patent No. 5701055, it may be necessary to form said ramparts on top of the insulating layer for either first or second bus electrodes, whichever formed later. For the fabrication of a monochrome display, a series of organic function materials are to be simply laminated. But the use of additional shadow mask(s) may be required for the construction of a multi or full color display: (1) putting a shadow mask onto top surfaces of the ramparts, the shadow mask having a plurality of openings each exposing one of either first or second electrodes, whichever suitable, between said ramparts, and aligning the openings to said electrodes respectively; (2) depositing first organic EL media through said openings onto said electrodes between said ramparts respectively, thereby forming first (R) organic function layers; (3) after realigning the shadow mask, repeating the process (2) to form second (G) and third (B) organic function layers; and (4) forming at least one second electrode on said ramparts and said organic function layers.

Fig. 10 illustrates the process of forming electrically insulating ramparts for pixelation as described in the above. Said ramparts 14 are formed on top of the insulating layer 13 which serves as a buffer layer here. An additional rampart 15 is required to electrically isolate second electrodes in A region from those in B region as illustrated in Fig. 11.

Next, organic function layers 16 are laminated as seen in Fig. 12. An exemplary green-emitting device may have organic function layers of: (1) a hole injecting buffer layer of copper phthalocyanine (CuPc) typically 10nm ∼ 20nm thick, (2) a hole transporting layer of N,N'-diphenyl-N,N'-bis(3-methylphenyl)-(1,1'-biphenyl)-4,4'-diamine (TPD) typically 30nm∼50nm thick. and (3) an emitting layer of tris(8-hydroxy-quinolate)aluminum (Alq₃) 40nm∼60nm thick which is often doped with a fraction of an emitting dye such as coumarin 6 or quinacridone. One of the preferred methods to fabricate a full color display panel is to laminate each of red, green and blue emitting materials onto the corresponding pixels step by step using a plurality of ramparts and shadow mask(s), as described earlier.

Fig. 13 illustrates the process of exposing a part of second bus electrode 10-b' by etching out organic function layers deposited right on top of said bus electrode 10-b' for the purpose of making an electrical contact between said bus electrode and the second electrode layer which is to be deposited in the following step (Fig. 14). The etching can be accomplished preferably using a dry etching process such as reactive ion etching or laser etching. Figures show, for clarity, only one window for electrical contact per each of second bus electrodes, but the number of said contact windows or connection pads may be increased to, for example, one per each pixel, if necessary. For most applications, one contact window per each bus electrode is sufficient because the material for a second electrode (Al, Mg:Ag or Al:Li) generally has much lower resistivity compared to that for a first electrode (ITO).

After the formation of second electrodes, the formation of protective layer(s) and an encapsulation process are followed to complete the panel fabrication.

The exemplary fabrication processes described for (4 x 4) sub-panels are applicable to the fabrication of an even larger panel of (6 x 6) sub-panels as shown in Fig. 15. Due to the symmetry involved, description with respect to only (3 x 3) sub-panels (fig. 16) should be sufficient to elucidate the fabrication steps of (6 x 6) sub-panels. The illustrations of Figs 17 - 24 concern the processing steps for said panel with (3 x 3) sub-panels, which are basically the same as those for (4 x 4) described already. But there are several differences as follows. As seen in Fig. 17, it is necessary to form one more bus electrodes per each first electrode compared to (4 x 4). Here two lanes of bus electrodes are shown to be laid down side by side, but it is also possible to form a multilayer structure by stacking a lane per each layer, as shown in Fig. 25(b). Fig. 20 shows again the presence of one more bus electrodes per each second electrode compared to (4 x4), i.e. 10-a, 10-b and 10-c.

In general, the fabrication scheme described above can be extended to the fabrication of a display panel with (2m x 2n) or (m x n) sub-panels. If so, as shown in Fig. 25, bus electrodes need to be formed in a multilayer structure. These multilayer bus electrodes may be formed either thin or thick film processing technologies. For reference, Fig. 26 is a perspective view describing the intersections of first and second bus electrodes.

Each of the sub-panels fabricated as described above can be driven using a driving circuitry which is separate, but not completely independent from the remaining circuitry. Separate driving here means that each sub-panel has separate scan and data lines which should be properly synchronized with the remaining circuitry.

The organic EL devices have the following advantages.

Effective driving of a large organic EL display panel has been made possible by forming a plurality of stripes for each of first electrodes and also for each of second electrodes. These stripes are electrically isolated from each other, which enables each group of pixels defined by a set of orthogonal stripes to be driven separately from the remaining groups of pixels. Efficient fabrication methods devised to construct said display panel are cost effective and suitable for mass production.

It will be apparent to those skilled in the art that various modifications and variations can be made in the organic electroluminescent display panels of the present invention without departing from the scope of the invention. Thus, it is intended that the present invention cover the modifications and variations of this invention provided they come within the scope of the appended claims and their equivalents.

## Claims

1. A passive electroluminescent display panel (1) comprising:
a substrate (3) having an emissive area and a non-emissive area around the emissive area;
a plurality of sub-panels (2) arranged in a column direction and a row direction of the emissive area of the substrate, each sub-panel having a plurality of emitting pixel regions;
a first electrode (4) formed at the plurality of emitting pixel regions in each sub-panel and divided from the first electrodes of adjacent sub-panels;
an organic light emitting layer (16) on the first electrode;
a second electrode (17) on the organic light emitting layer;
first and second pads (5,6) arranged in the non-emissive area of the substrate;
a first bus electrode (7-b) electrically coupled to the first pad (5) and the first electrode (4) of each sub-panel so as to electrically drive each sub-panel separately;
the first bus electrode (7-b) extending along a first direction;
a first insulating buffer layer (9) formed on the first bus electrode and extending along a second direction orthogonal to the first direction; and
a second bus electrode (10-b) formed along the second direction on top of the first insulating buffer layer, the second bus electrode being electrically coupled to the second pad (6) and by a protrusion (10-b') to the second electrode (17) of each sub-panel so as to electrically drive each sub-panel separately,
wherein a plurality of notches are formed on one side of the first electrode (4), the first electrode having a rectangular shape,
the protrusion (10-b') of then second bus electrode (10-b) extending into an area defined by a corresponding notch of said plurality of notches,
a second insulating layer (13) formed on top of the second bus electrode (10-b) along said second direction, the second insulating layer leaving exposed the second bus electrode at the notch (10-b');
wherein the area defined by the corresponding notch is exposed by etching the organic light emitting layer (16) deposited on top of the second bus electrode (10-b) so that the second electrode (17) is coupled to the second bus electrode (10-b) by said protrusion.

2. The organic EL display panel of claim 1, wherein the substrate (3) is made of a transparent insulating material.

3. The organic EL display panel of claim 1, wherein the emission area of the substrate (3) is divided into sub-panels (2) of m x n, wherein m is the number of sub-panels arranged in the column direction and n is the number of sub-panels arranged in the row direction, wherein m and n are integers greater than 2.

4. The organic EL display panel of claim 1, wherein the first electrode (4) is made of indium tin oxide (ITO), the second electrode (17) is Al, Mg:Ag, or Al:Li, and the first and second bus electrodes (7-b, 10-b) are made of at least one of aluminum, copper, nickel, chromium, silver and gold, alloys and conducting polymers.

5. The organic EL display panel of claim 1, wherein the first electrode (4-b) has a rectangular stripe shape, and the first bus electrode (7-b) is formed along a long side of the first electrode (4-b) such that the first bus electrode and the first electrode are in contact and the first bus electrode overlaps the first electrode at a side thereof.

6. The organic EL display panel of claim 1, wherein the first bus electrode (7-b) is contacted with at least one lateral surface of a corresponding first electrode (4) without overlapping each other.

7. The organic EL display panel of claim 1, wherein the first bus electrode (7-b) comprises a plurality of first bus electrodes vertically stacked with an insulating layer in between, and the second bus electrode (10-b) comprises a plurality of second bus electrodes vertically stacked with an insulating layer in between.

8. The organic EL display panel of claim 1, wherein the first bus electrode (7-b) comprises a plurality of first bus electrodes arranged side by side with an insulating gap in between, and the second bus electrodes (10-b) comprises a plurality of second bus electrodes arranged side by side with an insulating gap in between.

9. The organic EL display panel of claim 1, wherein each sub-panel (2) has a plurality of emitting pixels including the first and second electrodes (4, 17) and the organic light emitting layer layer (16) between them, the plurality of pixels of each sub-panel (2) is driven using a separate driving circuitry.

## Patentansprüche

1. Passives Elektrolumineszenz-Anzeigefeld (1), welches Folgendes aufweist:
ein Substrat (3), das eine emittierende Fläche und eine nicht-emittierende Fläche um die emittierende Fläche aufweist;
eine Vielzahl von Teilfeldern (2), die in einer Spaltenrichtung und in einer Reihenrichtung der emittierenden Fläche des Substrats angeordnet sind, wobei jedes Teilfeld eine Vielzahl von emittierenden Pixelbereichen aufweist;
eine erste Elektrode (4), die an der Vielzahl von emittierenden Pixelbereichen in jedem Teilfeld gebildet ist und von den ersten Elektroden angrenzender Teilfelder getrennt ist;
eine organische Lichtemissionsschicht (16) an der ersten Elektrode;
eine zweite Elektrode (17) an der organischen Lichtemissionsschicht;
erste und zweite Kontaktstellen (5, 6), die in der nicht-emittierenden Fläche des Substrats angeordnet sind;
eine erste Bus-Elektrode (7-b), die mit der ersten Kontaktstelle (5) und der ersten Elektrode (4) eines jeden Teilfelds elektrisch verbunden ist, so dass jedes Teilfeld separat elektrisch angesteuert wird;
wobei sich die erste Bus-Elektrode (7-b) entlang einer ersten Richtung erstreckt;
eine erste isolierende Pufferschicht (9), die an der ersten Bus-Elektrode gebildet ist und sich entlang einer zweiten Richtung, die orthogonal zur ersten Richtung ist, erstreckt; und
eine zweite Bus-Elektrode (10-b), die entlang der zweiten Richtung auf der Oberseite der ersten isolierenden Pufferschicht gebildet ist, wobei die zweite Bus-Elektrode elektrisch mit der zweiten Kontaktstelle (6) und über einen Vorsprung (10-b') mit der zweiten Elektrode (17) eines jeden Teilfelds verbunden ist, so dass jedes Teilfeld separat elektrisch angesteuert wird,
wobei eine Vielzahl von Kerben auf einer Seite der ersten Elektrode (4) gebildet sind, wobei die erste Elektrode eine rechteckige Form aufweist,
wobei sich der Vorsprung (10-b') der zweiten Bus-Elektrode (10-b) in eine Fläche erstreckt, die von einer entsprechenden Kerbe der Vielzahl von Kerben definiert ist,
eine zweite isolierende Schicht (13), die auf der Oberseite der zweiten Bus-Elektrode (10-b) entlang der zweiten Richtung gebildet ist, wobei die zweite isolierende Schicht die zweite Bus-Elektrode an der Kerbe (10-b') freigelegt lässt;
wobei die Fläche, die von der entsprechenden Kerbe definiert ist, durch Ätzen der organischen Lichtemissionsschicht (16), die auf der Oberseite der zweiten Bus-Elektrode (10-b) abgeschieden ist, freigelegt wird, so dass die zweite Elektrode (17) mit der zweiten Bus-Elektrode (10-b) über den Vorsprung verbunden ist.

2. Organisches EL-Anzeigefeld nach Anspruch 1, wobei das Substrat (3) aus einem transparenten isolierenden Material hergestellt ist.

3. Organisches EL-Anzeigefeld nach Anspruch 1, wobei die Emissionsfläche des Substrats (3) in m x n Teilfelder (2) unterteilt ist, wobei m die Anzahl von Teilfeldern ist, die in Spaltenrichtung angeordnet sind, und wobei n die Anzahl von Teilfeldern ist, die in Reihenrichtung angeordnet sind, wobei m und n ganze Zahlen größer als 2 sind.

4. Organisches EL-Anzeigefeld nach Anspruch 1, wobei die erste Elektrode (4) aus Indium-Zinnoxid (ITO) hergestellt ist, die zweite Elektrode (17) aus Al, Mg:Ag oder AI:Li besteht, und die erste und die zweite Bus-Elektrode (7-b, 10-b) aus wenigstens einem der folgenden Materialien hergestellt sind: Aluminium, Kupfer, Nickel, Chrom, Silber und Gold, Legierungen und leitende Polymere.

5. Organisches EL-Anzeigefeld nach Anspruch 1, wobei die erste Elektrode (4-b) eine rechteckige Streifenform aufweist, und die erste Bus-Elektrode (7-b) entlang einer langen Seite der ersten Elektrode (4-b) gebildet ist, so dass die erste Bus-Elektrode und die erste Elektrode in Kontakt sind und die erste Bus-Elektrode die erste Elektrode an einer Seite davon überlappt.

6. Organisches EL-Anzeigefeld nach Anspruch 1, wobei die erste Bus-Elektrode (7-b) mit wenigstens einer Seitenfläche einer entsprechenden ersten Elektrode (4) in Kontakt steht, ohne einander zu überlappen.

7. Organisches EL-Anzeigefeld nach Anspruch 1, wobei die erste Bus-Elektrode (7-b) eine Vielzahl von ersten Bus-Elektroden aufweist, die mit einer dazwischen liegenden isolierenden Schicht vertikal übereinander angeordnet sind, und wobei die zweite Bus-Elektrode (10-b) eine Vielzahl von zweiten Bus-Elektroden aufweist, die mit einer dazwischen liegenden isolierenden Schicht vertikal übereinander angeordnet sind.

8. Organisches EL-Anzeigefeld nach Anspruch 1, wobei die erste Bus-Elektrode (7-b) eine Vielzahl von ersten Bus-Elektroden aufweist, die mit einem dazwischen liegenden Isolierspalt nebeneinander angeordnet sind, und die zweiten Bus-Elektroden (10-b) eine Vielzahl von zweiten Bus-Elektroden aufweisen, die mit einem dazwischen liegenden Isolierspalt nebeneinander angeordnet sind.

9. Organisches EL-Anzeigefeld nach Anspruch 1, wobei jedes Teilfeld (2) eine Vielzahl von emittierenden Pixeln aufweist, die die erste und zweite Elektrode (4, 17) und die organische Lichtemissionsschicht (16) dazwischen einschließen, wobei die Vielzahl von Pixeln eines jeden Teilfelds (2) unter Verwendung einer separaten Ansteuerschaltung angesteuert wird.

## Revendications

1. Panneau d'affichage électroluminescent passif (1) comprenant :
un substrat (3) ayant une zone émissive et une zone non émissive autour de la zone émissive ;
une pluralité de sous-panneaux (2) agencés dans une direction de colonne et une direction de ligne de la zone émissive du substrat, chaque sous-panneau ayant une pluralité de régions de pixels émetteurs ;
une première électrode (4) formée au niveau de la pluralité de régions de pixels émetteurs dans chaque sou-panneau et séparée des premières électrodes de sous-panneaux adjacents ;
une couche émettant de la lumière organique (16) sur la première électrode ;
une seconde électrode (17) sur la couche émettant de la lumière organique ;
des premier et second plots (5, 6) agencés dans la zone non émissive du substrat ;
une première électrode de bus (7-b) couplée électriquement au premier plot (5) et à la première électrode (4) de chaque sous-panneau de manière à attaquer électriquement chaque sous-panneau séparément ;
la première électrode de bus (7-b) s'étendant le long d'une première direction ;
une première couche tampon isolante (9) formée sur la première électrode de bus et s'étendant le long d'une seconde direction orthogonale à la première direction ; et
une seconde électrode de bus (10-b) formée le long de la seconde direction au-dessus de la première couche tampon isolante, la seconde électrode de bus étant couplée électriquement au second plot (6) et par une saillie (10-b') à la seconde électrode (17) de chaque sous-panneau de manière à attaquer électriquement chaque sous-panneau séparément,
dans lequel une pluralité d'encoches sont formées sur un côté de la première électrode (4), la première électrode ayant une forme rectangulaire,
la saillie (10-b') de la seconde électrode de bus (10-b) s'étendant dans une zone définie par une encoche correspondante de ladite pluralité d'encoches,
une seconde couche isolante (13) formée au-dessus de la seconde électrode de bus (10-b) le long de ladite seconde direction, la seconde couche isolante laissant la seconde électrode de bus exposée au niveau de l'encoche (10-b') ;
dans lequel la zone définie par l'encoche correspondante est exposée par gravure de la couche émettant de la lumière organique (16) déposée au-dessus de la seconde électrode de bus (10-b) de sorte que la seconde électrode (17) soit couplée à la seconde électrode de bus (10-b) par ladite saillie.

2. Panneau d'affichage électroluminescent organique de la revendication 1, dans lequel le substrat (3) est réalisé à partir d'un matériau isolant transparent.

3. Panneau d'affichage électroluminescent organique de la revendication 1, dans lequel la zone d'émission du substrat (3) est divisée en m × n sous-panneaux (2), où m est le nombre de sous-panneaux agencés dans la direction de colonne et n est le nombre de sous-panneaux agencés dans la direction de ligne, où m et n sont des entiers supérieurs à 2.

4. Panneau d'affichage électroluminescent organique de la revendication 1, dans lequel la première électrode (4) est réalisée à partir d'oxyde d'indium-étain (ITO), la seconde électrode (17) est réalisée à partir d'Al, de Mg : Ag ou d'Al : Li, et les première et seconde électrodes de bus (7-b, 10-b) sont réalisées à partir d'au moins un élément parmi l'aluminium, le cuivre, le nickel, le chrome, l'argent et l'or, des alliages et des polymères conducteurs.

5. Panneau d'affichage électroluminescent organique de la revendication 1, dans lequel la première électrode (4-b) a une forme de bande rectangulaire, et la première électrode de bus (7-b) est formée le long d'un long côté de la première électrode (4-b) de sorte que la première électrode de bus et la première électrode soient en contact et la première électrode de bus chevauche la première électrode sur un de ses côtés.

6. Panneau d'affichage électroluminescent organique de la revendication 1, dans lequel la première électrode de bus (7-b) est mise en contact avec au moins une surface latérale d'une première électrode (4) correspondante sans se chevaucher.

7. Panneau d'affichage électroluminescent organique de la revendication 1, dans lequel la première électrode de bus (7-b) comprend une pluralité de première électrodes de bus empilées à la verticale avec une couche isolante au milieu, et la seconde électrode de bus (10-b) comprend une pluralité de secondes électrodes de bus empilées à la verticale avec une couche isolante au milieu.

8. Panneau d'affichage électroluminescent organique de la revendication 1, dans lequel la première électrode de bus (7-b) comprend une pluralité de premières électrodes de bus agencées côte à côte avec un jeu isolant au milieu, et les secondes électrodes de bus (10-b) comprennent une pluralité de secondes électrodes de bus agencées côte à côte avec un jeu isolant au milieu.

9. Panneau d'affichage électroluminescent organique de la revendication 1, dans lequel chaque sous-panneau (2) a une pluralité de pixels émetteurs comportant les première et seconde électrodes (4, 17) et la couche émettant de la lumière organique (16) entre elles, la pluralité de pixels de chaque sous-panneau (2) est attaquée en utilisant un ensemble de circuits d'attaque séparé.
